Europäisches Patentamt

(19) European Patent Office

Office européen des brevets

(11) Publication number: **0 265 076**
**A1**

(12) **EUROPEAN PATENT APPLICATION**

(21) Application number: **87308316.6**

(22) Date of filing: **21.09.87**

(51) Int. Cl.⁴: **G01R 1/20**

(30) Priority: **24.09.86 GB 8622940**

(43) Date of publication of application:
**27.04.88 Bulletin 88/17**

(84) Designated Contracting States:
**CH DE FR IT LI**

(71) Applicant: **The General Electric Company, p.l.c.**
**1 Stanhope Gate**
**London W1A 1EH(GB)**

(72) Inventor: **Joyce, Timothy Robert**
**Sycamores Yarnfield Lane**
**Yarnfield, Stone Staffordshire(GB)**

(74) Representative: **Pope, Michael Bertram Wingate**
**Central Patent Department Wembley Office**
**The General Electric Company, p.l.c. Hirst**
**Research Centre East Lane**
**Wembley Middlesex HA9 7PP(GB)**

(54) **Electrical measuring shunts.**

(57) An electric measuring shunt comprising a planar rectangular sheet (20) of electrically conductive material having a rectangular aperture (22) formed therein. Located at the mid-points of each of the pair of shorter edges (26) of the sheet (20) are first and second terminals (28, 30) whereby the shunt may be connected in the path of an electric current. Located at the mid-points of each of the pair of shorter edges (37, 39) of the aperture (22) are third and fourth terminals (32, 34) whereby the potential difference ($V_{fg}$) representative of the current may be measured. The first, second, third and fourth terminals (28, 30, 32, 34) lie substantially on an axis of symmetry (V-W) with regard to the current flow in the shunt, so as to avoid the presence of inductive loops.

*Fig. 3.*

## Electrical Measuring Shunts

This invention relates to electrical measuring shunts.

More particularly the invention relates to electrical measuring shunts of the kind comprising a planar member of electrically conductive material, first and second terminal means at opposite ends of the member whereby the member may be connected in the path of an electric current and third and fourth terminal means at spaced positions between said first and second terminal means such that the potential difference between said third and fourth terminal means is representative of the value of the said current.

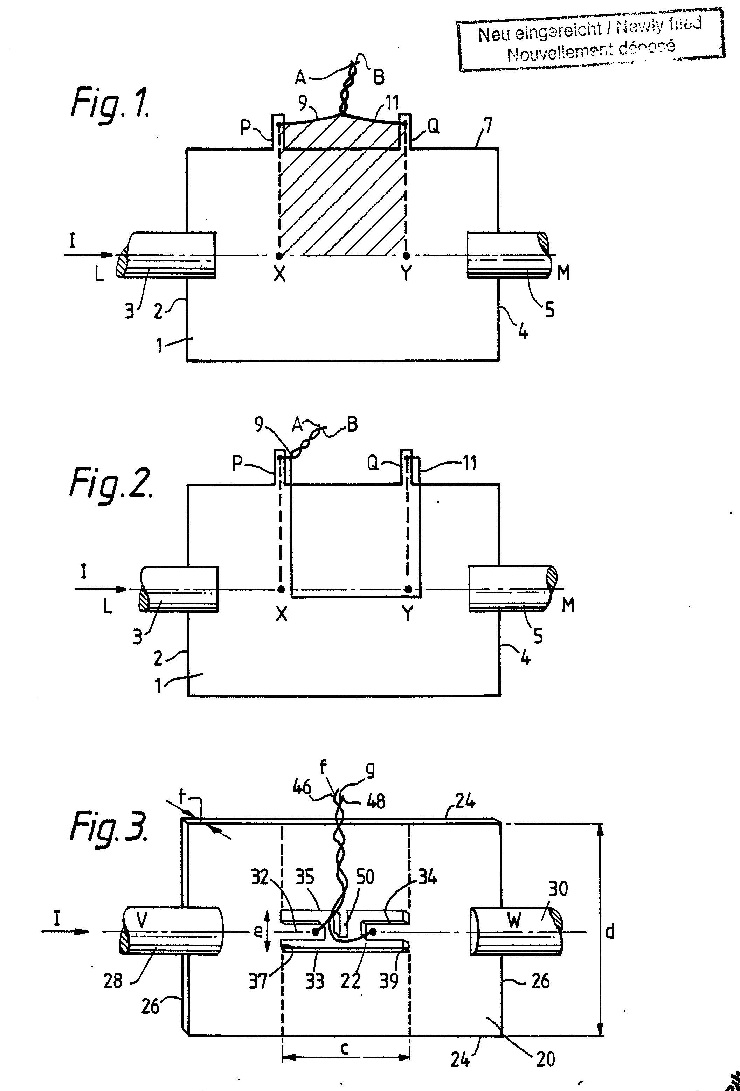

One known electrical measuring shunt of the above kind is shown in Figure 1. The shunt comprises a planar rectangular member 1 provided at the centre of each of one pair of opposite shorter edges 2, 4 with a terminal means in the form of a lead wire 3 or 5. Along one longer edge 7 of the member 1 are two spaced apart terminal means in the form of a lead wire 3 or 5. Along one longer edge 7 of the member 1 are two spaced apart teminal means in the form of projections P, Q. Respectively connected to these projections P, Q are the ends of a twisted pair of wires, 9, 11.

In operation, with the shunt connected by means of wires 3, 5 in the path of an electric current I, the potential difference $V_{ab}$ between the ends A, B of the wires 9, 11 will have a main component equal to the potential difference $V_{xy}$ between the points X, Y on the straight line LM between the lead wires 3, 5. However, in addition to this any change of magnetic flux $\phi$ passing through the shaded area PQYX, such as would occur, for example, if the current I was an alternating current, will induce a voltage in the "loop" PQYX. Hence the measured voltage $V_{ab}$ may be expressed as:

$$V_{ab} = V_{xy} + \frac{d\phi}{dt} = IR_{xy} + \frac{d\phi}{dt} \quad -(1)$$

where t is time and $R_{xy}$ is the resistance between the two points X and Y.

One known electrical measuring shunt in which the presence of such an undesirable loop is avoided is shown in Figure 2. The arrangement is as shown in Figure 1 except that the wire 11 connected to the projection Q is arranged to overlie the path QYXP. Beyond P the wire 11 is twisted around the wire 9, as in the arrangement of Figure 1.

An arrangement as shown in Figure 2 is disclosed in US-A-4,494,068.

Although the arrangement shown in Figure 2 avoids the existence of an inductive "loop", precise positioning of the wire 11 along the path QYXP is required to avoid all inductive effects. This precise positioning complicates the production of such a measuring shunt, especially when mass production is required.

It is an object of the present invention to provide an alternative form of electrical measuring shunt which avoids the existence of inductive loops, the shunt being also suitable for the mass production thereof.

According to the present invention there is provided an electrical measuring shunt comprising: a planar member of electrically conductive material; first and second terminal means at opposite ends of said member whereby the member may be connected in the path of an electric current, and third and fourth terminal means at spaced positions between said first and second terminal means such that the potential difference between said third and fourth terminal means is representative of the value of said current, characterised in that said first, second, third and fourth terminal means lie substantially on an axis of symmetry with regard to the flow of said electric current in said member.

One electrical measuring shunt in accordance with the invention will now be described, by way of example, with reference to Figure 3 of the accompanying drawings which is a diagrammatic view of the shunt.

Referring to Figure 3, the shunt comprises a planar rectangular electrically conductive member 20 of thickness $t$ having a rectangular central aperture 22, the aperture 22 having its longer edges parallel to the longer edges 24 of the member 20.

Midway along each of its shorter edges 26 the member 20 is provided with a terminal in the form of a lead wire 28 or 30.

Midway along each of the shorter edges of the aperture 22 there is terminal means in the form of a rectangular projection 32 or 34, the lead wires 28 and 30 and the projections 32 and 34 thus lying on the axis of symmetry VW of the member 20. The lengths of the longer edges 33, 35 of the aperture 22 are denoted by $c$, the lengths of the shorter edges 37, 39 of the aperture 22 are denoted by $e$ and the lengths of the shorter edges 26 of the member 20 are denoted by $d$. Respectively connected to the projections 32, 34 are the ends of a twisted pair of wires 46, 48.

In operation, with the shunt connected by means of wires 28, 30 in the path of a current I, no inductive loop is present which will contribute to the potential difference $V_{fg}$ between the ends f and g of wires 46, 48. This is because the lead wires 28, 30 and the projections 32, 34 all lie along an axis of symmetry VW with regard to the flow of current I in the member 20. The potential difference $V_{fg}$ is therefore given:

$$V_{fg} = I\ R_{fg} \qquad -(2)$$

Where $R_{fg}$ is the resistance between the projection 32 and 34. If $\rho$ is the resistivity of the electrically conductive material comprising the member 20 then to a very good approximation:

$$R_{fg} = \frac{\rho c}{(d-e)t} \qquad - (3)$$

Hence with a knowledge of the dimensions and resistivity of the member 20, measurement of the voltage $V_{fg}$ provides a measurement of the current I flowing in the shunt.

If the circuitry utilising the potential difference $V_{fg}$ requires a further input indicative of the potential of the current path in which the shunt is connected, this is suitably derived from a projection 50 positioned midway along a longer edge 33 or 35 of the aperture 22. The common mode voltage of the potential $V_{fg}$ with respect to the potential at projection 50 is then zero.

It will be understood that whilst the provision of the aperture 22 in the member 20 facilitates the connection of the wires to the member, the presence of an aperture in the shunt according to the invention is not essential.

## Claims

1. An electrical measuring shunt comprising: a planar member (20) of electrical conductive material; first and second terminal means (28, 30) at opposite ends (26) of said member (20) whereby the member (20) may be connected in the path of an electric current, and third and fourth terminal means (32, 34) at spaced positions between said first and second terminal means (28, 30) such that the potential difference ($V_{fg}$) between said third and fourth terminal means (32, 34) is representative of the value of said current, characterised in that said first, second, third and fourth terminal means (28, 30, 32, 34) lie substantially on an axis of symmetry (V-W) with regard to the flow of said electric current in said member (20).

2. A shunt according to Claim 1 wherein said member (20) is symmetric about said axis (V-W).

3. A shunt according to Claim 2 wherein said planar member (20) is rectangular and said first and second terminal means (28, 30) lie at the mid-points of a pair of opposite sides (26) of said member (20).

4. A shunt according to any one of the preceding claims wherein said third and fourth terminals means (32, 34) lie at spaced apart positions on the edge of an aperture (22) extending through said member (20).

5. A shunt according to Claim 4 when dependent on Claim 3 wherein said aperture (22) is rectangular and said third and fourth terminal means (32, 34) lie at the mid-points of a pair of opposite sides (37, 39) of said aperture (22), said pair of opposite sides (37, 39) of said aperture (22) being parallel to said pair of opposite sides (26) of said member (20).

6. A shunt according to Claim 4 including a further terminal means (50) lying on the edge (35) of said aperture (22) midway between said third and fourth terminal means (32, 34).

7. A shunt according to any one of Claims 4, 5 and 6 wherein said aperture (22) is centrally disposed with respect to said member (20).

Fig. 1.

Fig. 2.

Fig. 3.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.3) |
|---|---|---|---|
| X | DE-B-2 114 466 (GOSSEN GMBH) <br> * complete document * <br> --- | 1-7 | G 01 R 1/20 |
| A | US-A-3 330 027 (W.N. KERNANDER et al.) <br> * figures 1, 2, 4 * <br> --- | 1 | |
| A | US-A-4 001 684 (D.H. FRITTS) <br> * abstract * <br> --- | | |
| A | EP-A-0 030 186 (ENERTEC SOC.) <br> * abstract; figure 1 * & US - A - 4 494 068 (Cat. A,D) <br> ----- | | |

TECHNICAL FIELDS
SEARCHED (Int. Cl.3)

G 01 R 1/20
H 01 C 3/02

The present search report has been drawn up for all claims

| Place of search | Date of completion of the search | Examiner |
|---|---|---|
| BERLIN | 10-12-1987 | LEMMERICH J |

EPO FORM 1503 03.82 (P0401)